# EUROPEAN PATENT APPLICATION

(11) **EP 1 215 011 A1**
(43) Date of publication of application: **19.06.2002**
(21) Application number: 00127481.0
(22) Date of filing: 14.12.2000
(51) Int. Cl.: B24B 37/04, B24B 41/06

(54) **Arrangement and method for mounting a backing film to a polish head**

(71) Applicant: Infineon Technologies SC300 GmbH & Co. KG, 01099 Dresden (DE)
(72) Inventor: Ebner, Katrin, 01109 Dresden (DE); Erdmann, David, 01097 Dresden (DE); Glashauser, Walter, 82041 Oberhaching (DE); Teichgräber, Lutz, 01468 Moritzburg (DE)
(74) Representative: Fischer, Volker, Dipl.-Ing.

(57) **Abstract**

Applying heat and pressure to a backing film (3) comprising an adhesive layer (4) during the procedure of mounting it to a polish head (1) for use in chemical mechanical polishing (CMP), inhomogeneities inside the adhesive layer (4), e.g. thickness and compressibility variations or air bubbles (101), can easily be removed. A corresponding arrangement comprises a means for exerting a uniform pressure force (51), which can be a roller (51a) made of silicone or rubber, or a plate (51b), a means for heating (61) and a control unit (5) for controlling the heat and the pressure force. The backing film (3) installed using this Arrangement and method provides a uniform removal of material from the semiconductor wafer (2) surface and therefore advantageously increases the wafer yield.

## Description

The present invention relates to an arrangement and a method for mounting a backing film to a polish head, the polish head having a surface for contacting said backing film, the backing film having an adhesive layer.

With the advent of smaller feature sizes below quarter micron in semiconductor wafer manufacturing the process of chemical mechanical polishing (CMP) has become increasingly important to planarize newly deposited or grown layers and non-uniform surfaces on semiconductor devices, e.g. wafers. The semiconductor wafer to be polished is pressed to a pad, onto which a slurry is continuously conducted, and the pad, which is mounted on a polishing table, is moved relative to the wafer. The slurry distributed between the wafer and the pad contains abrasive with a size of typically 10-50 nanometers for mechanically removing material from the wafer surface, as well as active chemical additives, which provide a selective removal of material, e.g. tungsten.

The uniform removal of material from the wafer surface can be supported by mounting a backing film to the polish head on the backside of the wafer. In this case the wafer is held by said polish head to which the backing film is mounted. The wafer comprises a system of vacuum holes connecting the wafer backside to a vacuum for holding the wafer prior to polishing. During polishing the wafer is commonly released from said vacuum holes. The backing film serves for damping and outweighing the tension of single abrasive particles exerted from beneath the wafer and for shielding against particles frictioning on the wafer backside. The wafer, when sucked to the polish head or when lying on the slurry and the pad below the polish head is surrounded by floating or fixed retaining rings for preventing the wafer edges from intenser abrasion as compared with the inner parts, thus providing a uniform polishing across the wafer. The polishing movement commonly comprises a rotation of the polish head with the semiconductor wafer beneath around a first axis and a rotation of the table with the polish pad around a second axis.

Due to material fatigue caused, e.g., by particle contamination the backing film has to be replaced with new material on a regular time basis. For most CMP apparatus this is performed by manually unmounting the polish head from the apparatus, removing the old backing film from the polish head and then manually sticking on a new backing film. Backing films consisting of e.g. polyurethane commonly have an adhesive layer on one of it's surfaces. The process of manually sticking on the backing film often involves an accidental enclosement of small air bubbles between the adhesive layer of the backing film and the backing plate, i.e. the polish head. These air bubbles lead to a located pressure on the wafer backside and therefore result in spots the wafer frontside, which are exposed relative to their surroundings. During polishing the removal of the wafer frontside surface material located in those exposed spots is rather intense and can lead to the damage of the corresponding chip, thereby decreasing the yield significantly.

Moreover, the adhesive layer varies in material characteristics, e.g. thickness, compressibility across the backing film. These non-uniformities in the backing film directly influence the uniformity of removal of material from the semicinductor wafer surface as well. Since the mounting of backing films depends on the skills of the operators, the disadvantages are still increased. The monitoring of the process in order to undertake corrections is rendered impossible in default of process reproducibility.

It is therefore a primary object of this invention to increase the yield in semiconductor wafer manufacturing by improving the quality of the chemical mechanical polishing process.

This objective is solved by an arrangement and a method for mounting a backing film to a polish head for polishing disklike objects, preferably semiconductor wafers, the polish head having a surface for contacting said backing film, the surface being provided with vacuum holes, the backing film having an adhesive layer, comprising a means for holding said polish head, and a means for exerting a pressure force on said surface of the polish head, when being covered by said backing film, and a means for heating the backing film.

Using the arrangement and the method according to the present invention the backing film comprising the adhesive layer is mounted to and sticked on the polish head by applying coincidently pressure and temperature to the backing film. Under the influence of temperature the adhesive layer liquifies and can easily be redistributed between the backing film and the polish head by applying a pressure force onto the backing film. E.g., applying a uniform pressure force across the backing film surface a uniform adhesive layer thickness emerges straightforwardly.

Moreover, the occurrence of air bubbles that are enclosed between the adhesive layer and the polish head can be significantly reduced by applying a locally dependent pressure force, that starts to act at some location on the backing film and moves continuously across the backing film such that air bubbles are continuously shifted until they reach the edge of the backing film and thus eventually leave the adhesive layer. Another advantage arises from the reproducibility of the process. Since all parts of the arrangement can be monitored and controlled by a control unit, the influence of personal on the mounting process can be reduced and the quality of sticking on the adhesive layer can be improved.

While the means for exerting a pressure force on said surface of the polish head and the control unit can still be represented by an operator, these two ingredients are preferentially provided by some mechanics or logic, respectively. Additionally, an integration of the arrangement according to the present invention into a CMP-tool is possible as well.

The steps of applying a higher temperature by a means for heating and of applying a pressure force by a means for exerting a pressure force can be performed either coincidentally in parallel or subsequently. However, the viscous, or liquid characteristics of the adhesive layer due to the heat should be given, when the application of the pressure force onto the backing film is started.

Another advantageous aspect considers the use of a roller for exerting the pressure force onto the backing film. In particular the roller is efficient in removing the air bubbles between the adhesive layer and the polish head by leading them to the edge of the backing film and by redistributing melted adhesive material below the backing film. The roller surface is preferably made of rubber or silicon but any other material is possible as well. The roller is led by a roller guide, which is responsible for rolling the roller across the backing film thereby exerting a uniform pressure force at any location on the backing film.

In order to control the pressure force either the roller guide means or the means for holding the polish head can be adjusted in there height relative to the plane defined by the backing film. In case of the roller guide means being adjustable a uniform pressure force at all locations on the backing can be guaranteed by preferably realizing two of them on each side of the roller. The adjustment unit of the means for holding the polish head also has to provide the characteristic, that the surface of the polish head, which has to be covered by the backing film is essentially parallel to the axis of the roller. By providing such characteristics the process of mounting a backing film to a polish head can be repeated with high coincidence and reproducibility even in the case of differing operators.

A further improvement is the aspect of connecting an energy source in the motor for moving the roller. This feature further reduces the need for skill and routine of the operators. Preferably an electric motor is used which can be adjusted in its velocity.

In a further aspect a plate is considered due to which the pressure force can be exerted upon the backing film. The surface of the plate is sufficiently planar and preferably has the size of the backing film. Once the polish head is mounted to the means for holding the polish head according to the arrangement of the present invention and the polish head is covered with the backing film the plate can be released, and the polish head or the plate can be moved into the direction of each other using a motor with their respective surfaces being essentially parallel to each other. When they have met they are acting on each other with a pressure force pressing the backing film and the adhesive layer onto the polish head. In order to impede a shearing movement of the backing film the movement of the plate or the polish head and the pressure force are perpendicular to the surface of the polish head and the backing film.

In a further aspect the heating of the backing film is considered. The means for exerting a pressure force, e.g. the roller or the plate, can be heated and by heat transport the heat can be transferred to the backing film and the adhesive layer. A sensor enables the operators to control the temperature, which on the one hand side should be constant during the mounting procedure and on the other hand should not increase beyond a threshold value in order to prevent damaging the, e.g., polyurethane backing film material.

In a further aspect an additional sensor for measuring the pressure force is considered. Using e.g. a set of 3 sensors the distribution of pressure force across the backing film can be measured and compared in order to guarantee a uniform process.

A complete process control is enabled in a further aspect. Utilizing a control unit in the mode of closed loop control the motor, the means for heating and the means for exerting a pressure force can be controlled such as to run in a self-regulating configuration. This aspect gives the advantage of full process monitoring, especially further quality improvement by correcting and adjusting parameters.

In a further aspect the polish head as the source for the heat transferred to the backing film is considered. The advantage is, that the adhesive layer can be directly addressed by the heat instead of a heat transport via the backing film.

In a further aspect, a means for aligning the backing film, i.e. the perforation of said backing film, with the vacuum holes, which have to penetrate the backing film in order to contact the, e.g., semiconductor wafer, is considered. Such a means, when incorporated into the present arrangement, accelerates the process of mounting the backing film, and therefore advantageously leads to a significant saving of time for manufacturing disklike objects, e.g. wafers.

Further advantageous features, aspects and details of the invention are evident from the dependent claims.

The invention is now described with reference to embodiments taken in conjunction with the accompanying drawings, wherein
- figure 1: shows the process of chemical mechanical polishing using a polish head and a backing film, as it is state of the art;
- figure 2: shows a first, simple embodiment illustrating the method according to the present invention using a workbench and an iron handled and controlled by an operator;
- figure 3: shows a top view of a second embodiment according to the present invention;
- figure 4: shows a side view (a), and the arrangement of the closed loop control circuit (b) of the second embodiment according to the present invention;
- figure 5: shows a side view of a third embodiment according to the present invention;
- figure 6: shows the results of an experiment to verify uniformity after chemical mechanical polishing with different backing film mounting procedures.

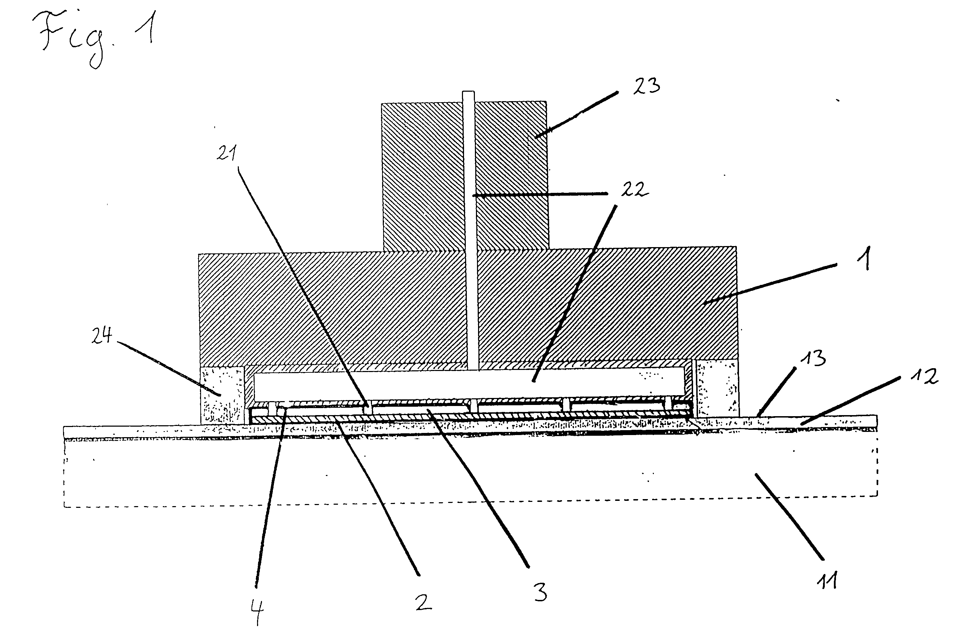

The state-of-the-art configuration of a polish head during polishing is shown in figure 1. The polish head 1 is connected to a polishing arrangement via a connection peace 23 and is thereby rotated. Vacuum chambers 22 are used to hold the semiconductor wafer 2 prior to polishing by sucking the semiconductor wafer 2 to vacuum holes 21 distributed over the planar - or nearly planar - surface of polish head 1. In order to start the polishing the polish head 1 is moved to the polishing table 11 which is covered by a polish pad 12 on which a slurry 13 is distributed containing abrasive and chemical additives. When a contact between polish head 1 and the polish pad 12 has been established semiconductor wafer 2 is released from vacuum holes 21 such that there is a slight pressure from backing film 3 to the backside of semiconductor wafer 2. Floating retaining rings 24 protect the wafer edges from experiencing a particularly intensive removal of material. Backing film 3 being perforated in order to receive vacuum holes 21 has an adhesive layer 4 by which it is sticked to polish head 1.

When polishing the polish head 1 holds semiconductor wafer 2 with the help of the backing film 3 which serves for outweighing non-uniformities acting on semiconductor wafer 2 from the backside as well as from the frontside. Due to material fatigue and particle contamination the backing film 3 has to be exchanged from time to time.

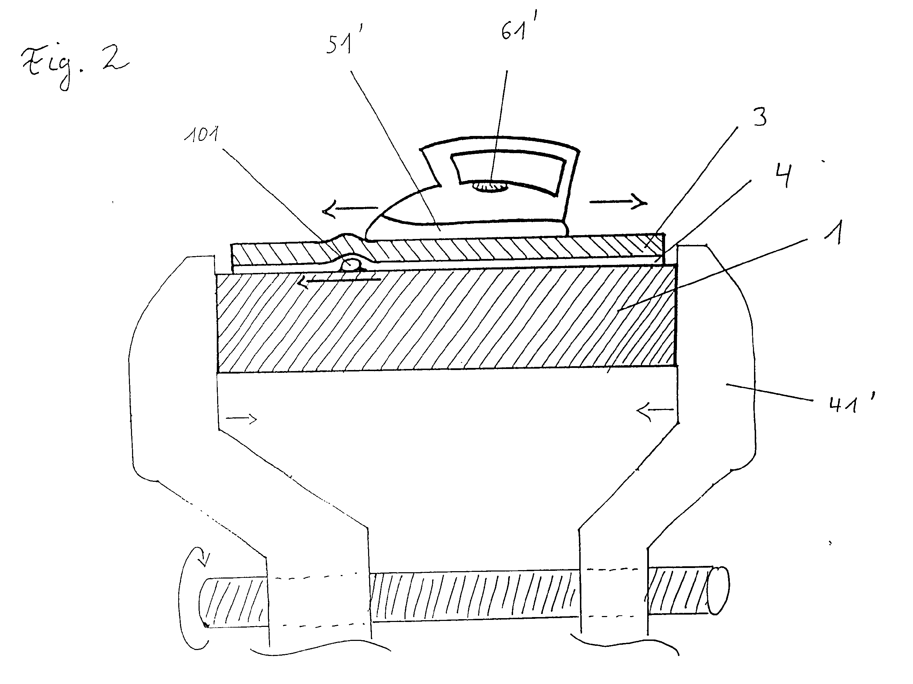

Using a first simple embodiment the method according to the present invention will be now explained with reference to figure 2.

After polishing, i.e. no semiconductor wafer 2 is held by vacuum holes 21, polish head 1 is unmounted from the connection peace 23 of the polishing arrangement, and clamped into a work bench 41', the surface being to receive the backing film 3 with the adhesive layer 4 positioned, e.g., on the topside. The operator then removes the backing film 3 comprising the adhesive layer 4 from a foil and puts it onto the surface of polish head 1. Thereby he aligns the perforation of backing film 3 with the vacuum holes 21 of the polish head 1. In order to remove air bubbles 101, which are eventually enclosed between the adhesive layer 4 and the polish head 1, the operator takes an iron as both a means for exerting a pressure force 51' and a means for heating 61' and starts ironing the backing film 3. Selecting an appropriate temperature of the iron and waiting for a sufficient time such that a constant temperature is established the adhesive layer 4 becomes viscous and the air bubble can be moved beneath the backing film 3 by exerting a pressure force on backing film 3. Moving the iron continuously across the surface the air bubble 101 will eventually be pressed out of the adhesive layer 4. In this embodiment the operator controls, whether the means for heating, i.e. the iron, does not overheat backing film 3, as well as providing the whole surface of backing film 3 with a uniform pressure force.

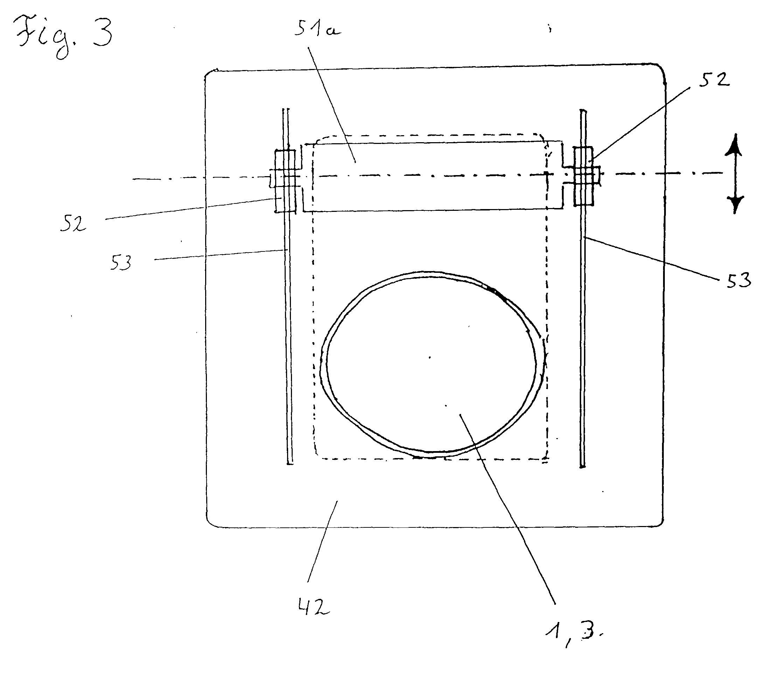

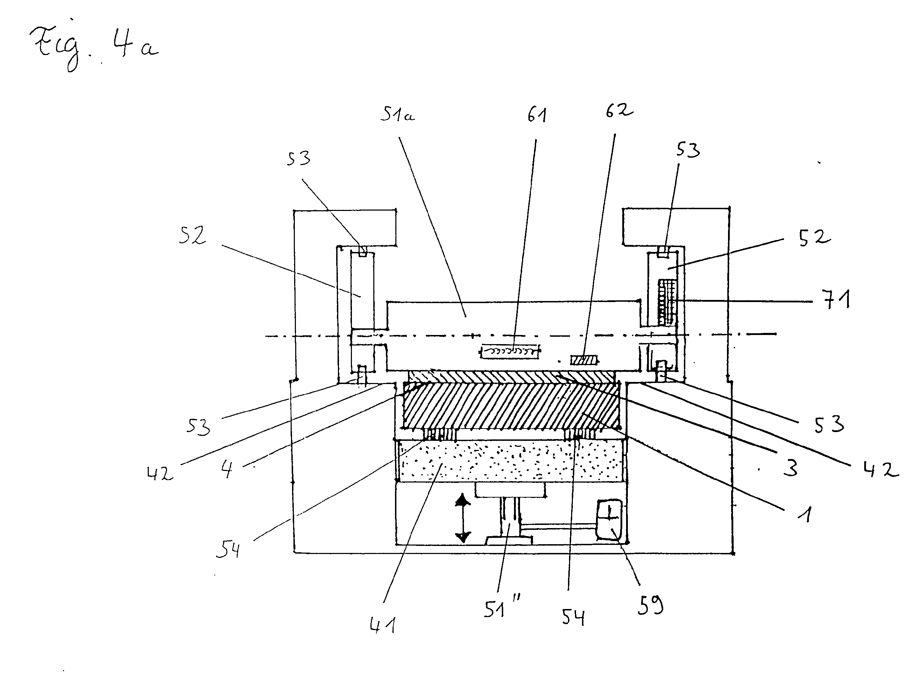

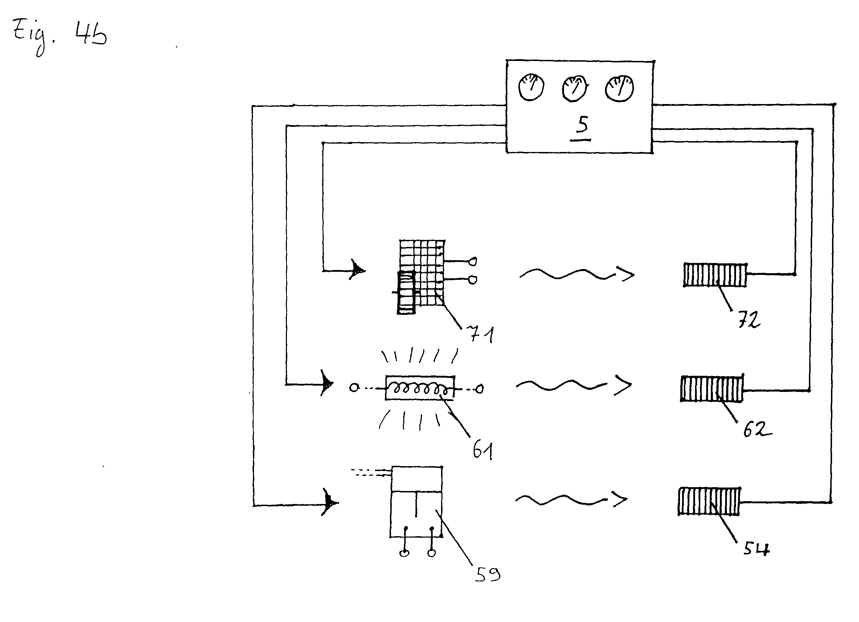

A second embodiment according to the present invention is illustrated in figures 3 and 4, where the top and side views are respectively shown. The unmounted polish head 1 is held by a means for holding a polish head 41 beneath, and the surface of polish head 1, which has to receive backing film 3 is positioned in about the same plane as it is stretched up by a guide rail system 53 carrying roller guides 52. These roller guides 52 lead a roller 51 serving as a means for exerting a pressure force across said playing stretched by the surface of polish head 1. The apparatus top plate 42 preferably is positioned in the same plane in order to protect the backing film edges when the roller is starting to contact the surface of polish head 1.

When the backing film 3 is laid upon polish head 1 with it's perforation aligned to vacuum holes 21 roller guides 52 are started to move along guide rail 53 thereby rolling roller 51 across apparatus top plate 42 and then across the surface of polish head 1 covered by backing film 3 with the adhesive layer 4 orientated towards polish head 1. Roller guide 52 is driven by an electric motor 71 as can be seen in the sideview of figure 4a. While roller 51 exerts the pressure force for ironing the backing film 3, the means for holding the polish head 41 is adjustable in it's height by a pneumatic cylinder 51'' in case the pressure force has to be varied. E.g., the polish head 1 can be lifted down in order to move roller 51 to a position above the center of the polish head 1, after which the polish head 1 can be raised again to the ironing level. Then, the process of ironing can be started moving the roller 51 from the center position outwards in order to remove air bubbles 101 from beneath the adhesive layer 4.

In order to liquify the adhesive layer for removing air bubbles 101 or material inhomogeneities the roller 51 comprises a means for heating 61 for heating the roller surface and thus the backing film. Corresponding rollers 51, e.g. made from silicone or rubber, are generally available from specialized trade. Such rollers 51 are heatable up to 100°C, sufficient to melt or liquify the adhesive layer 4.

While the guide rail system is adjustable in its height at 4 different locations in order to achieve a plane for the roller axis that is parallel to the surface of polish head 1, the strength of the uniform pressure force can be controlled by a source for pressure 59 which acts on the pneumatic cylinder 51''. The pressure force that is actually exerted upon backing film 3 is measured by sensors 54, or load cells, which are connected to a control unit 5, as can be seen in figure 4b. The pressure force is commonly maintained within a range of pressure values, which is controlled by control unit 5. This is achieved by connecting control unit 5 and the energy supply to the pressure source 59, which acts on the means for exerting a pressure force, i.e. the pneumatic cylinder 51''. There is also a temperature measuring sensor 62 sending signals to control unit 5 in order to maintain the heat transfer supplied by the means for heating 61 to be held constant or at least beneath a threshold value, to prevent the backing film 3 from heat damage.

To exert the pressure force in a uniform manner by the roller 51 rolled across the backing film 3, also the velocity of the roller guide driven by the electromotor 71 is controlled by control unit 5, which receives signals from a velocity sensor 72. This sensor 72 can be replaced, if a tight relationship between energy supply by control unit 5 and the resulting roller guide velocity is known.

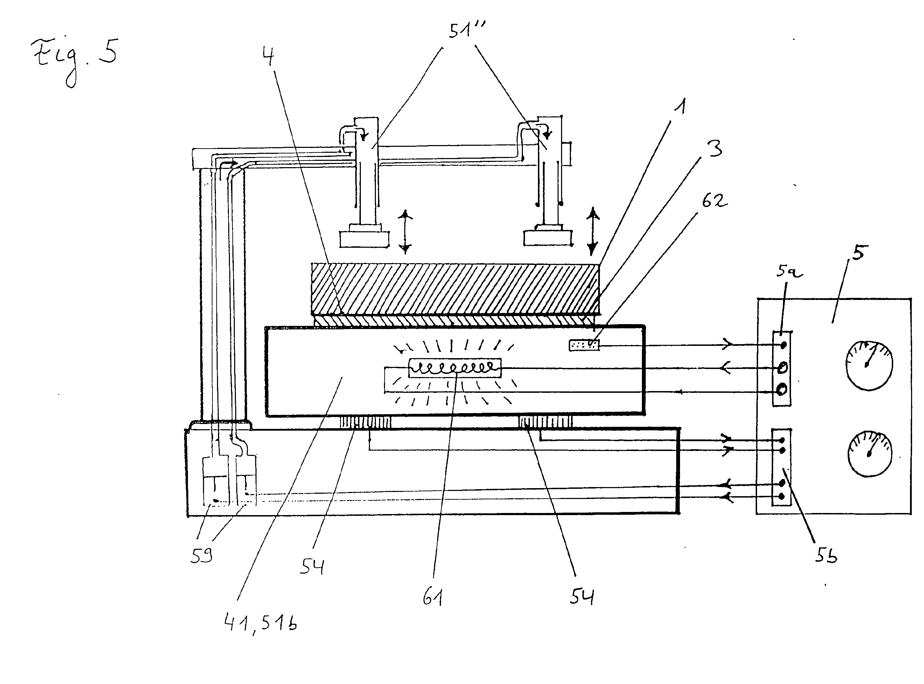

A third embodiment of the method and apparatus according to the present invention is shown in figure 5, where the polish head 1 with its surface directed to the bottom is pressed onto the means for holding a polish head 41 being a plate, whereby the backing film 3 is positioned between them and the adhesive layer 4 contacting the surface of polish head 1. The pressure force is exerted by pneumatic cylinders 51 pressing polish head 1 down onto the plate. Multiple pneumatic cylinders 51 are used as means for exerting a pressure force, each of them being supplied with pressure by separate sources for pressure 59, because the pressure force acting on polish head 1 can then be balanced in order to exert a uniform pressure force. To accomplish this multiple sensors 54 are installed beneath the means for holding the polish head 41 in order to measure the distribution of pressure force across the polish head 1. From these elements a closed loop control circuit is established by a control unit 5b.

The means for holding the polish head 41, i.e. the plate, comprises a means for heating 61 and a sensor 62 for heating the backing film 3 and the adhesive layer 4, and are controlled by control unit 5a. If the heat transferred to the backing film 4 increases the temperature measured by sensor 62 beyond a maximum threshold value, control unit 5a reduces energy supply to the means for heating 61 and the temperature decreases again.

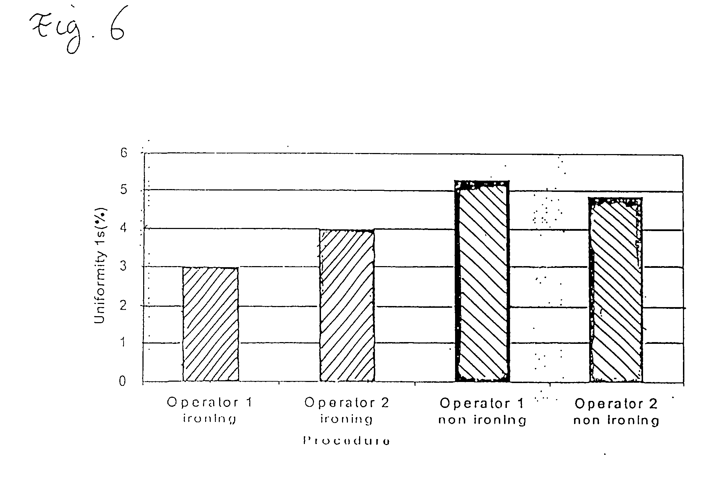

These embodiments provide a means due to which air bubbles 101 and inhomogeneities of the adhesive layer for mounting backing films 3 are advantageously removed. Therefore, using this method and apparatus the uniformity will significantly be reduced, which is shown in figure 6. There, the thickness uniformity has been monitored for two different operators, which carried out several mounting processes either using the ironing procedure, i.e. the first embodiment described above, or the conventional procedure mounting the backing film 3 manually without heating. The 1-σ-uniformity value expressed in percent of total thickness reaches a value of 5,1 % for the conventional mounting mode, and a value of 3.5 % for mount the backing film 3 with the iron. Using the full advantage of the method and apparatus according to the present invention of the second and third embodiment an even stronger reduction in uniformity can be expected. Such reduction in uniformity ranges directly leads to a significant increase in semiconductor wafer yield and quality.

## Claims

1. Arrangement for mounting a backing film (3) to a polish head (1) for polishing disklike objects, preferably semiconductor wafers, the polish head (1) having a surface for contacting said backing film (3), the surface being provided with vacuum holes (21), the backing film (3) having an adhesive layer (4), comprising
- a means for holding said polish head (41), and
- a means for exerting a pressure force (51) on said surface of the polish head (1), when being covered by said backing film (3), and
- a means for heating (61) the backing film (3).

2. Arrangement according to claim 1,
**characterized in that**
said means for exerting a pressure force (51) comprises
- a roller (51a) having an axis, which is parallel to said surface of the polish head (1), and
- a roller guide (52) for guiding the roller (51a) parallel to said surface of the polish head (1), when said polish head (1) is held by the means for holding the polish head (41).

3. Arrangement according to claims 2,
**characterized in that**
at least one of said roller guide (52) or said means for holding the polish head (41) comprise a means for adjusting the distance of said roller axis to said surface of the polish head (1).

4. Arrangement according to claims 2 or 3,
**characterized in that**
said roller guide means (52) is connected to an energy source and a motor (71) for moving the roller.

5. Arrangement according to claim 1,
**characterized in that**
the means for exerting a pressure force (51) comprises a plate (51b), the plate (51b) having a surface parallel to the surface of the polish head (1), and the plate (51b) being disposable relative to said surface of the polish head (1).

6. Arrangement according to anyone of claims 2 to 5,
**characterized in that**
the means for heating (61) is provided to heat said means for exerting a pressure force (51) for melting the adhesive layer (4), said means for exerting a pressure force (51) comprising at least one sensor for measuring the temperature (62).

7. Arrangement according to anyone of claims 2 to 6,
**characterized in that**
at least one of said means for holding the polish head (41) or the means for exerting the pressure force (51) comprise at least one sensor for measuring the pressure force (54) exerted on said surface of the polish head (1) covered by the backing film (3).

8. Arrangement according to anyone of claims 6 to 7,
**characterized in that**
a control unit (5) is connected to at least one of said sensor for measuring the temperature (62), the means for heating, said sensor for measuring the pressure force (54) or said means for exerting a pressure force (51).

9. Arrangement according to anyone of claims 1 to 8,
**characterized in that**
the means for heating (61) is provided to heat the polish head (1).

10. Arrangement according to anyone of claims 1 to 9,
**characterized in that**
said arrangement comprises a means for aligning the backing film (3) to the vacuum holes (21) mounted on the polish head (1).

11. Method for mounting a backing film (3) to a polish head (1), the polish head (1) having a surface mounted with vacuum holes (21), for contacting said backing film (3), the backing film (3) having an adhesive layer (4), comprising the steps of
- holding said polish head (1),
- covering the surface of the polish head (1) with the backing film (3),
- heating the backing film (3),
- controlling the heating temperature using a control unit (5) and a sensor for measuring temperature (62), and
- exerting a pressure force on the backing film (3) perpendicular to the surface.

12. Method according to claim 11,
**characterized by**
rolling a roller (51a) across the surface of the polish head (1) covered by the backing film (3).

13. Method according to claim 11,
**characterized in that**
the pressure force is exerted on the surface of polish head (1) covered by the backing film (3) by pressing a plate (51b) onto said surface of polish head (1).

14. Method according to anyone of claims 12 or 13,
**characterized by**
measuring the temperature of the means for exerting the pressure force (51) and adjusting the heat in response to a signal from the sensor for measuring the temperature (62).

15. Method according to anyone of claims 12 to 14,
**characterized by**
measuring the pressure force exerted on the surface of the polish head (1) when being covered by the backing film (3), and adjusting the pressure force in response to a signal from the sensor for measuring the pressure force (54).
